# EUROPEAN PATENT APPLICATION

(11) **EP 1 510 965 A1**
(43) Date of publication of application: **02.03.2005**
(21) Application number: 03730756.8
(22) Date of filing: 02.06.2003
(51) Int. Cl.: G06K 17/00

(54) **CARD ADAPTER**

(30) Priority: 04.06.2002 JP 2002162499
(71) Applicant: MATSUSHITA ELECTRIC INDUSTRIAL CO., LTD., Kadoma-shi, Osaka 571-8501 (JP)
(72) Inventor: MATSUDA, Takashi, Hirakata-shi, Osaka 573-0088 (JP); SAKUTA, Hiroshi, Osaka-shi, Osaka 538-0043 (JP); HORIE, Naoya, Neyagawa-shi, Osaka 572-0801 (JP)
(74) Representative: Grünecker, Kinkeldey, Stockmair & Schwanhäusser Anwaltssozietät
(86) International application number: PCT/JP2003/006918
(87) International publication number: WO 2003/102863

(57) **Abstract**

The card adapter disclosed has the configuration that: all of the parts are mounted on a same surface of the circuit board in a foldable structure; the circuit board is folded until both boards face each other to insert into the card case; and the space just above the holder for a compact memory card is made up with the card case. This can realize a low profile connector for a compact memory card to provide a card adapter with CF type I compliant shape.

## Description

### TECHNICAL FIELD

The present invention relates to a card adapter to connect a removable compact memory card to portable information equipments represented by PC (personal computer), PDA (personal digital assistants), digital still camera or the like.

### BACKGROUND ART

Recent notebook computers (personal computers) are generally provided with PC card slots. The PC card inserted in the slot can extend functionalities of the notebook computers.

The PC card satisfies the PC Card Standard with a flat rectangular shape of 54.0 mm wide, 85.6 mm long, and 3.3 mm (type I), 5.0 mm (type II) and 10.5 mm (type III) high respectively. However, as even the PC card is not compact enough to meet strong requirements for downsizing in recent portable information equipment represented by PDAs or digital still cameras, a CF card that is more compact in size has been introduced in many cases.

The CF card represented by the Flash memory card is used to store images taken by digital still cameras or schedule and address data in PDAs. The CF card compliant with the CompactFlash Association Standard (hereafter referred to as the first specification) has a flat rectangular shape of 36.4 mm wide, 42.5 mm long, and 3.3 mm (type I) and 5.0 mm (type II) high respectively. Most recent PDAs and digital cameras adopt 3.3 mm high model (type I) being advantageous for product downsizing.

On the other hand, compact memory cards specialized in memory have been used widely for digital still cameras, silicon-audio players or the like as a storage media. These compact memory cards having memory IC chips or controller IC chips and directly packaged using resin have a feature of extremely low profile. Smart media cards and MMCs (MultiMedia Cards) belong to this category. Moreover, the SD memory card (Secure Digital memory card) having copyright protection functions has become very popular recently with its compact size, large capacity and high transfer rate. Hereafter, standard for these compact memory cards is referred to generically as the second specification.

The age of real multi-media has come and portable information equipments and notebook personal computers have become very popular due to the achievements of downsizing and high functionalities in portable information equipment.

In this situation, for instance, transferring images taken by digital still camera to notebook PCs to edit pictures on the PCs or exchanging data between PDAs and notebook PCs are enjoyed everyday. Most notebook PCs are, however, not provided with slots to insert the compact memory card directly while CF cards or other compact memory cards are well established as storage media. To meet the requirements to connect the CF cards or compact memory cards to PC card slot formed according to the PC Card Standard, the PC card adapter has been provided so far.

Most modern PDAs or digital still cameras have been provided with slots for CF cards but have no slots to insert MMC or the SD cards directly that have been used widely in recent years. Until now, any card adapter compliant with 3.3 mm (type I) for PDAs or digital still cameras has not yet been developed.

The reason is that designing a card adapter thinner than CF type I is physically impossible as the compact memory cards have a thickness almost similar to CF type I.

Information equipment having CF card slots compliant with the CompactFlash Association Standard have to satisfy a precondition specified in the standard: the compact memory card side must have a signal processing circuit to convert signals between the first specification and the second specification. Compact memory cards, therefore, without carrying the signal processing circuit cannot be used directly in the CF card slots.

Therefore, to connect the compact memory cards to information equipment having the CF card slots, a CF-card-shaped card adapter provided with a signal processing circuit to convert data between both specifications is necessary.

For instance, as disclosed in Japanese Patent Laid-Open Application No. 2000-214970, conventional CF-card-shaped card adapter has slot connectors mounted on the top surface of an internal circuit board to form a holder for a compact memory card. On the bottom surface of the internal circuit board, the signal processing circuit is formed to convert signals between both specifications. Therefore, the thickness of the card adapter can be the minimum when followings are stacked with no space in between: a holder for a compact memory card or a slot connector; a circuit board; parts for the signal processing circuit; and metal covers to cover top and bottom surfaces of the card adapter.

Even in this case, to produce a card adapter thinner than CF type I is physically impossible as compact memory cards have thickness near to that specified for CF type I. Therefore, as disclosed for instance in Japanese Patent Laid-Open Application No. 2000-214970, a card adapter compliant with CF type II has been realized (shaped 36.4 mm wide, 42.5 mm long and 5.0 mm high as specified in CompactFlash Association Standard).

In another example, to allow a card adapter to connect to information equipment having CF type I slot, a card adapter has been realized complying the width and thickness of the card adapter with respect to the insertion direction with CF type I and extending the longitudinal length along the insertion direction longer than CF type I.

Similarly, another CF type I "compatible" card adapter has been realized that holds a compact memory card in the holder with an end portion extending out of the card adapter.

As conventional compact memory cards have thicknesses approximately equal to the thickness specified for CF type I, commercializing a CF type I card adapter has been physically difficult that must satisfy following three requirements: (1) capable of connecting to information equipment having a CF type I slot, (2) capable of including whole of the holder for a compact memory card and the signal processing circuit, (3) capable of holding a compact memory card without any extrusion out of the CF type I card adapter.

Japanese Patent Laid-Open Application No. 2000-214970 discloses a CompactFlash Association Standard type II compliant card adapter. Portable information equipment, however, represented by PDA or digital still camera has been in many cases provided with CF type I card slot due to strong needs for downsizing. As the result, the present situation is that many portable information equipment with CF type I card slot cannot connect to type II card adapter.

Most portable information equipments are provided with a protection lid for card slot inlet. Additionally, some of the equipments have a function to detect closing of the lid and causing the equipment not to start operation unless the lid is closed perfectly. Therefore, card adapters with a longitudinal elongation along the card slot or card adapters with an inserted compact memory card having an extrusion from the end of adapter even though the card adapter itself has the CF type I compliant shape cannot be used for these equipment.

Most usual card adapters are made up to insert a compact memory card from the rear end. Structures of card adapter with an inserted compact memory card having an extrusion from the end have risks to drop off from the card adapter by unexpected external forces. In some card adapters such as disclosed in Japanese Patent Laid-Open Application No. 2000-214970, the power supply control for compact memory cards, so-called "hot plugging", is simplified as the aforementioned problems is solved by modifying the adapter structure. However, detection of insertion and removal of a compact memory card in the card adapter has been an essential function.

### SUMMARY OF THE INVENTION

The present invention aims at solving the conventional problems with the first purpose of providing a CF type I card adapter that can includes all of the holder for a compact memory card and the signal processing circuit, and can hold a compact memory card without any extrusion out of the CF type I card adapter.

The second purpose is to provide a card adapter with an improved reliability by forming an adapter structure capable of preventing the compact memory card from dropping off or from removing while the card adapter is in the card slot, and a simple structure by simplifying the power supply control for the compact memory card and by eliminating the detection of insertion and removal of the compact memory card.

The card adapter of the present invention is to connect a compact memory card compliant with the second specification to the CF card slot compliant with the CompactFlash Association Standard or the first specification.

The card adapter includes a circuit board and a card case, and
the circuit board has:
a first connector compliant with the first specification;
a second connector compliant with the second specification; and
a signal processing circuit connected to the first connector and the second connector to convert signals between the first specification and the second specification, and
the card case accommodating and including the circuit board has:
a compact memory card inlet perpendicular to the insertion direction of the card slot compliant with the first specification,
wherein the card case and the second connector form the holder for the compact memory card, and the card case makes up the top portion of the holder for the compact memory card.

### BRIEF DESCRIPTION OF THE DRAWINGS

Fig. 1 is a perspective view of an outline of the card adapter used in the preferred embodiment of the present invention.
Fig. 2 is a cross-sectional view of the card adapter along the line A - A shown in FIG. 1.
Fig. 3 is an exploded perspective view of the card adapter shown in FIG. 1.
Fig. 4 is a plan view of the circuit board used in the preferred embodiment of the present invention.
Fig. 5 is a side view of the circuit board used in the preferred embodiment of the present invention.
Fig. 6 is a plan view of the circuit board in a folded condition used in the preferred embodiment of the present invention
Fig. 7 is a side view of the circuit board in a folded structure used in the preferred embodiment of the present invention
Fig. 8 is a cross-sectional view of the circuit board along the line B - B shown in FIG. 7.
Fig. 9 is an expanded partial side view of the circuit board in a folded structure used in the preferred embodiment of the present invention
Fig. 10 is an exploded perspective view of the card adapter shown in FIG. 1.

### DETAILED DESCRIPTION OF THE PREFERRED EMBODIMENTS

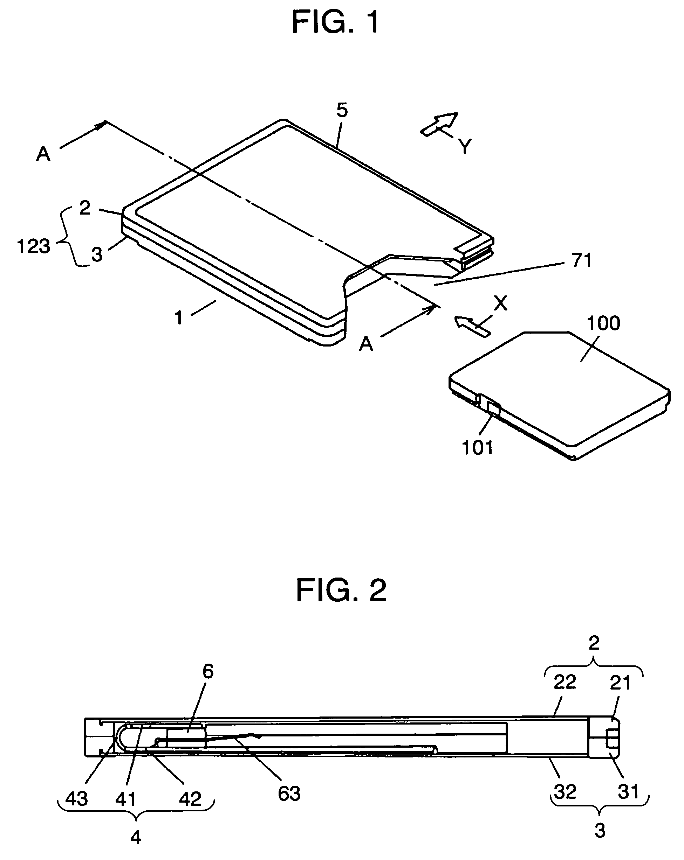

The card adapter of the present invention is described with reference to drawings. As shown in FIG. 1, card adapter 1 comprises first case 2, second case 3, CF slot connector 5, and card inlet 71. Card case 123 is an assembly of first case 2 and second case 3. SD card 100 has a write protect switch 101 on a side surface. An insertion direction of SD card is indicated by arrow X, and an insertion direction of the card adapter to information equipment is indicated by arrow Y.

FIG. 2 shows a cross-sectional view taken along the line A -A of card adapter 1 shown in FIG. 1. First case 2 is an integral mold of first resin frame 21 and first metal cover 22. Second case 3 is an integral mold of second resin frame 31 and second metal cover 32. First resin frame 21 and second resin frame 31 are carried out ultrasonic welding. First metal cover 22 and second metal cover 32 can shield circuit board 4 including signal processing circuit (not shown) from external electric noises or static electricity and can protect noise radiations from circuit board 4.

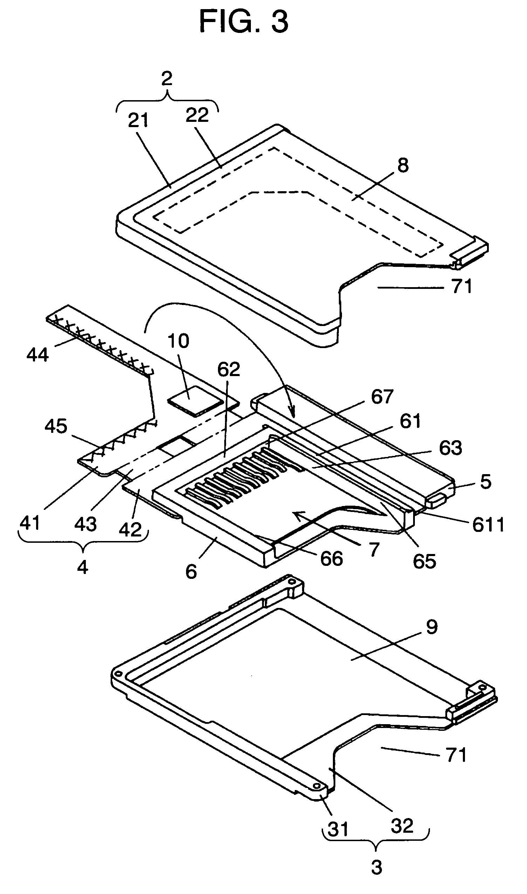

Circuit board 4 is sandwiched between first case 2 and second case 3. First metal cover 22 and second metal cover 32 contact to circuit board 4. Main board 41 is insulated electrically from first metal cover 22 appressed to main board 41 by first insulation sheet 8 shown in FIG. 3. Similarly, sub-board 42 is insulated electrically from second metal cover 32 appressed to sub-board 42 by second insulation sheet 9.

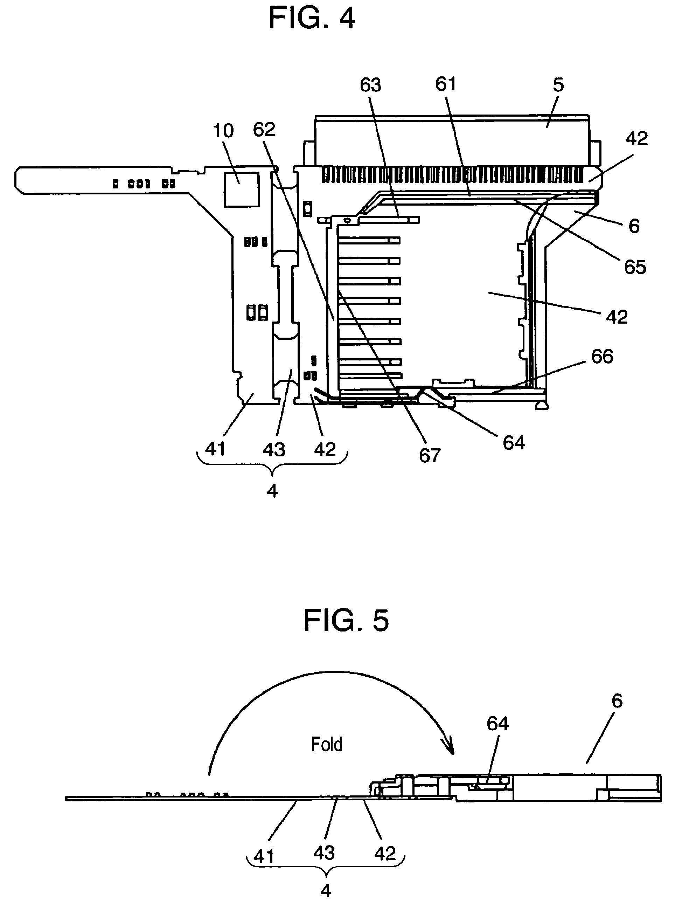

FIG. 3 shows an exploded perspective view of card adapter 1 shown in FIG. 1. Circuit board 4 including signal processing circuit (not shown) comprises main board 41, sub-board 42 and flexible bend 43. Additionally, the card adapter includes: CF slot connector 5, SD card connector 6, circuit board first support (first support) 61, first upper support 611, circuit board second support (second support) 62, terminals 63, first guide 65, second guide 66, third guide 67, card inlet 71, first insulation sheet 8, second insulation sheet 9, controller IC chip 10 and write protect switch terminal 64 as shown in FIG. 4.

Here, SD card connector 6 makes up a housing including first support 61, first upper support 611, second support 62, first guide 65, second guide 66 and third guide 67. SD card connector 6 includes first support 61 and second support 62. The adapter structure allows first contact portion 44 of circuit board 4 to touch first support 61, and second contact portion 45 of circuit board 4 to touch second support 62 when circuit board 4 is folded to opposite faces. If first support 61 and second support 62 have a same height, and the step between first upper support 611 and first support 61 is equal to the thickness of circuit board 4, the bottom surface of circuit board 4 and first upper support 611 come to a same level when circuit board 4 is folded.

FIG. 4 is a plan view showing whole of the circuit board shown in FIG. 3. The card adapter has a structure so as to form SD card holder 7 by first guide 65, second guide 66 and third guide 67 of SD card connector 6 respectively. FIG. 5 is a side view of circuit board 4 shown in FIG. 4 before folding, that is, before insertion into card case 123.

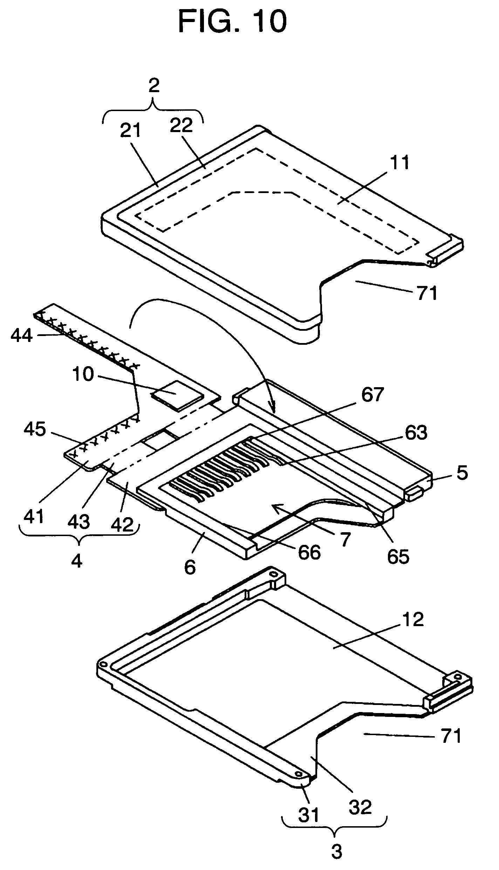

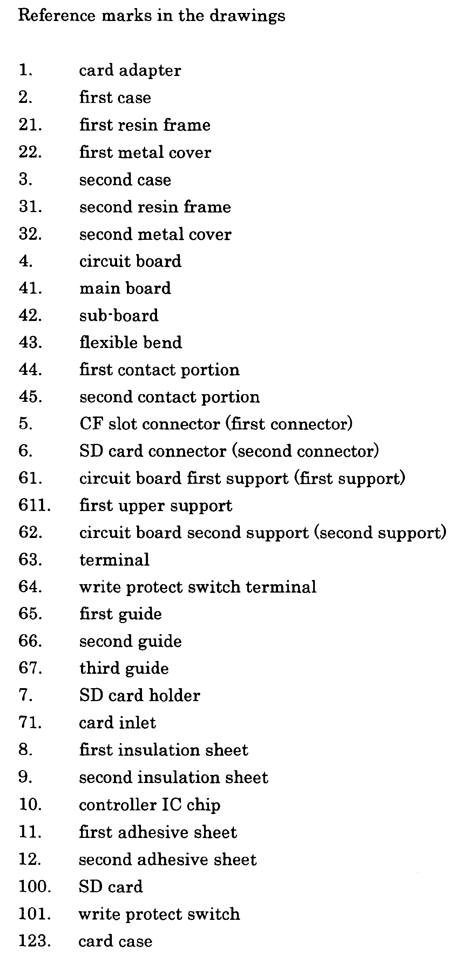

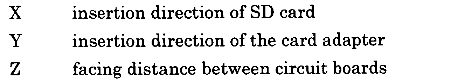

FIG. 10 shows another preferred embodiment of the card adapter in the present invention. After circuit board 4 is folded and inserted into card case 123, circuit board 4 is fixed by insulating adhesives applied inner face of card case 123, providing SD card connector 6 with no support for circuit board 4. For instance, first adhesive sheet 11 and second adhesive sheet 12 are both resin sheets having rubber adhesives such as polybuden or the like. The embodiment is to form the holder for a compact memory card on SD card connector 6 by first guide 65, second guide 66, third guide 67 and first metal cover 22 as shown in FIG. 3.

In another aspect of the present invention, the insertion direction of SD card (X) is at right angle to that of the adapter (Y) as shown in FIG. 1. The configuration can prevent SD card 100 inserted in card adapter 1 from being removed while running. Therefore, a mechanism to switch on/off power supply from SD card connector 6 to SD card 100 or a mechanism to detect any compact memory card in the adapter can be eliminated as shown in FIG. 4.

Still another aspect is that main board 41 of circuit board 4 is generally L-shaped so as to prevent SD card holder 7 from being blocked when folded to the opposite face of sub-board 42 as shown in FIG. 5.

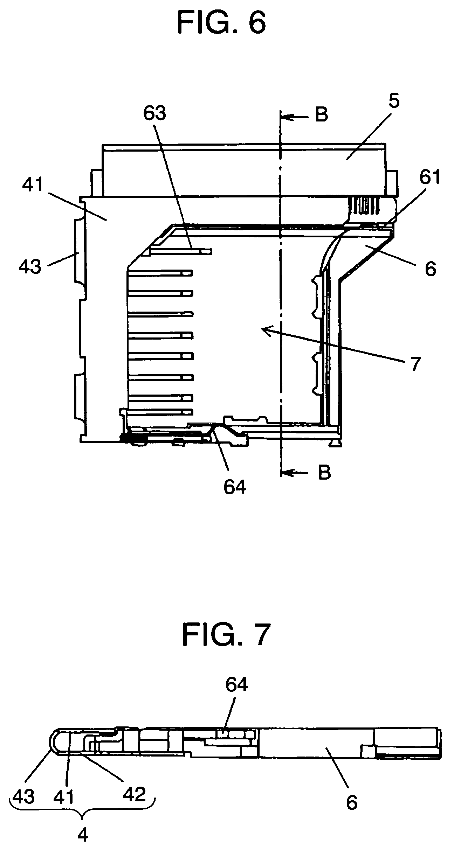

Still another aspect is described with reference to FIGs. 5 & 6. When main board 41 is folded to the opposite face of sub-board 42, first contact portion 44 and second contact portion 45 of circuit board 4 are appressed to first support 61 and to second support 62 respectively enabling distance (Z) between the facing circuit boards to keep a prescribed dimension.

Still another aspect is described again with reference to FIGs. 5 & 6. When main board 41 is folded to the opposite face of sub-board 42, first adhesive sheet 11 and second adhesive sheet 12 provided on first metal cover 22 and on second metal cover 32 respectively, resinous sheets applied with rubber-based adhesives such as polybuden or the like as shown in FIG. 10 can keep distance (Z) between the facing circuit boards in a prescribed dimension.

Still another aspect is a configuration in that signal processing circuit such as controller IC chip is not installed in circuit board 4. That is, CF slot connector 5 is connected to SD card connector 6 electrically, and that circuit to convert pin arrangement is installed in circuit board 4.

### (PREFERRED EMBODIMENT 1)

The card adapter of the present invention is described in detail further with reference to preferred embodiment 1.

Card adapter 1 is an assembly of first case 2 and second case 3 bonded together by ultrasonic welding to form card case 123 as shown in FIG. 1. First case 2 is an integral mold of first resin frame 21 and first metal cover 22. Second case 3 is also an integral mold of second resin frame 31 and second metal cover 32. Then, first resin frame 21 and second resin frame 31 are ultrasonically welded to complete card case 123.

Circuit board 4 including signal processing circuit (not shown) as a main part, is folded and held in card case 123 composed of first case 2 and second case 3 bonded together.

CF slot connector 5, which is a first connector compliant with the first specification, is disposed on the front edge facing CF type I slot, and SD card inlet 71 to insert SD card 100 is disposed on one side of the adapter. That is, the insertion direction (X) of SD card 100 for card adapter 1 is at right angle to the insertion direction (Y) of adapter 1.

In this embodiment, the top of SD card connector 6, which is a second connector compliant with the second specification, contacts first metal cover 22. Therefore, SD card connector 6 and first metal cover 22 hold SD card 100 inserted in SD card holder 7. The configuration can provide SD card connector 6 with the minimum thickness as no press mechanism is needed to SD card 100 from above SD card connector 6.

To shield circuit board 4 from external electric noise or static electricity and to protect noise radiations from circuit board 4, first case 2 and second case 3 have integral molded first metal cover 22 and second metal cover 32 respectively.

Circuit board 4, held between first case 2 and second case 3, is appressed to first metal cover 22 and second metal cover 32. First insulation sheet 8 insulates main board 41 from first metal cover 22 appressed to main board 41 electrically. Second insulation sheet 9 insulates sub-board 42 from second metal cover 32 appressed to sub-board 42 electrically.

SD card connector 6 surface-mounted on circuit board 4, the main part of card adapter 1, is disposed at the back of SD card holder 7. SD card 100 inserted from inlet 71 is coupled to card adapter 1 mechanically as well as electrically.

SD card 100 is a sheet-type card embedding a resin packaged IC (not shown) with a plurality of terminals disposed on the bottom surface.

Card adapter 1 has circuit board 4 internally, and circuit board 4 includes main board 41, sub-board 42 and flexible bend 43 to connect main board 41 and sub-board 42.

Main board 41 includes mainly controller IC chip and its peripheral circuits (not shown), and is formed generally L-shaped in plan view.

Sub-board 42 carries mainly CF slot connector 5, SD card connector 6 and its peripheral circuits (not shown).

Flexible bend 43 includes a wiring conductor (not shown) to connect circuits between main board 41 and sub-board 42.

Circuit board 4 includes: CF slot connector 5 compliant with the first specification; SD card connector 6 compliant with the second specification; and signal processing circuit mainly involving controller IC chip 10 and its peripheral circuits (not shown).

A signal processing circuit (not shown) is disposed in the card adapter so as to use a compact memory card compliant with the second specification in an equipment provided with a card slot compliant with the first specification. This is because the signal processing circuit is necessary in any one of followings: equipment with a card slot; a compact memory card compliant with the second specification; and a card adapter to insert a compact memory card.

The signal processing circuit (not shown) receives, via pattern wiring of circuit board 4, signal compliant with the first specification to and from CF slot connector 5 and signal compliant with the second specification to and from SD card connector 6. Then the signal processing circuit (not shown) converts data between both specifications.

SD card connector 6 mounted on sub-board 42 includes: terminals 63 corresponding to the terminals (not shown) disposed on the bottom surface of SD card 100; and write protect switch terminal 64 corresponding to write protect switch 101 disposed on a side surface of SD card 100. Terminals 63 and 64 are made of a resilient conductive material

First support 61 and second support 62 are disposed on the top surface of external periphery of SD card connector 6. The configuration can hold first contact portion 44 and second contact portion 45 of main board 41 when circuit board 4 is folded, and can keep distance (Z) between main board 41 and sub-board 42 facing each other in a prescribed dimension.

SD card connector 6 has first guide 65, second guide 66 and third guide 67 internally to limit front and right and left sides positions of inserted SD card.

As the insertion direction (X) of SD card is at right angle to the insertion direction (Y) of the card adapter, SD card 100 can be inserted to or extracted from card adapter 1 only when card adapter 1 is out of the card slot. As a result, the ability of insertion/removal of SD card 100 with card adapter 1 being coupled (in a running state) to equipment (not shown), so-called hot plugging, needs not be assured. Therefore, terminals to switch on/off the power supply from SD card connector 6 to SD card 100 or to detect any SD card 100 remaining in the adapter are not necessary any more.

Both first support 61 and second support 62 disposed on the top surface of external periphery of SD card connector 6 form a step equal to the thickness of the circuit board and can provide distance (Z) between main board 41 and sub-board 42 folded to face each other in a prescribed dimension.

At the time, what is important is that parts mounted on main board 41 and facing parts mounted on sub-board 42 must be disposed so as not to collide with each other. That is, a 3 dimensional designing is required to dispose parts such that the sum of heights of facing parts does not exceed the distance (Z) between two facing boards when circuit board 4 is folded.

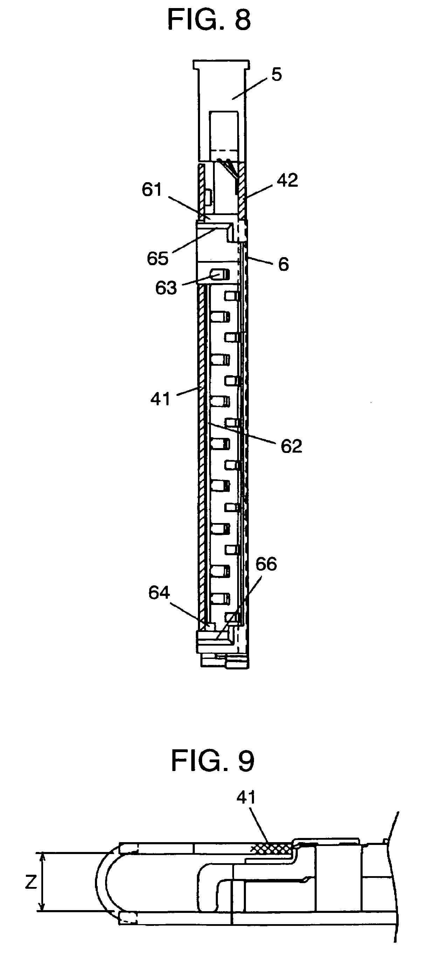

Structure of circuit board 4, folded at flexible bend 43 until main board 41 faces sub-board 42, and inserted into card adapter 1 are shown in FIGs. 6 to 8. As main board 41 is formed generally L-shaped, even if main board 41 is folded to the opposite face of sub-board 42, the top of SD card connector 6 is open. That is, main board 41 has an open area equal to or wider than SD card holder 7 at the place facing SD card holder 7. In preferred embodiment 1, main board 41 is formed L-shaped to form an open area. However, the form is not limited to L-shape but for instance main board formed U-shaped for forming the open space may be also acceptable. As main board 41 does not cover SD card connector 6, the thickness of card adapter 1 can be the height stacking: first metal cover 22; SD card connector 6; sub-board 42; second insulation sheet 9; and second metal cover 32. That is, as the thickness of main board 41 is not added to the total height, card adapter 1 can be thinner accordingly.

Though circuit board 4 includes main board 41, sub-board 42 and flexible bend 43 in preferred embodiment 1, integrating main board 41 and sub-board 42 can eliminate flexible bend 43.

### (PREFERRED EMBODIMENT 2)

Next, preferred embodiment 2 that provides distance between main board 41 and sub-board 42 of folded circuit board 4 with a prescribed dimension is described

FIG. 10 shows the card adapter used in preferred embodiment 2 of the present invention. Instead of first support 61 and second support 62 used for SD card connector 6 in preferred embodiment 1, insulating adhesive is employed. Adhesive sheet 11, for instance, is applied on first metal cover 22 appressed to main board 41, and adhesive sheet 12 is applied on second metal cover 32 appressed to sub-board 42. The configuration can hold the facing distance (Z) between boards of the folded circuit board in a prescribed dimension. Adhesive sheet is a resinous sheet applied with rubber-based adhesives such as polybuden or the like. The configuration can eliminate first insulation sheet 8 and second insulation sheet 9 used in preferred embodiment 1.

Needless to say, the adhesive fixing is not limited to rubber adhesives such as polybuden or the like.

Additionally, needless to say, even a kind of circuit board 4, having no signal processing circuit (not shown), that connects CF slot connector 5 to SD card connector 6 electrically by pattern wirings to convert pin arrangements without carrying any signal conversion can be adopted in preferred embodiment 2 of the present invention.

Next, the operation of card adapter of the present invention is described.

Card adapter 1 having an outline identical to CF type I compliant with the CompactFlash Association Standard (the first specification) has SD card holder 7 to insert SD card 100 compliant with SD Card Association Standard (the second specification) internally. As SD card 100 is inserted in SD card holder 7 without any extrusion, card adapter 1 with inserted SD card 100 can become a CF type I card. By introducing card adapter 1 of the present invention, therefore, PDAs or digital still cameras with CF type I slot can use SD card 100.

Card adapter 1 has the structure with: CF slot connector 5 disposed on front edge surface of card adapter 1 facing CF type I card slot; and SD card inlet 71 formed on a side surface of card adapter 1. That is, insertion direction (X) of SD card 100 with respect to card adapter 1 is at right angle to insertion direction (Y) of card adapter 1 with respect to CF type I card slot. This can prevent SD card 100 inserted in card adapter 1 from being removed while running. Consequently, there is no need to take into account the so-called "hot plugging", and detection of insertion and removal of SD card 100 in the adapter may be eliminated. Therefore, the configuration enables to design card adapter 1 easily with a simplified structure of SD card connector 6 and to improve the product reliability.

Although the embodiments are explained when the invention is applied to SD card, the invention is also applied to Multi Media Card.

### INDUSTRIAL APPLICABILITY

As described above, the present invention can realize a card adapter having a signal processing circuit to convert signals between the first specification and the second specification with a card thickness compliant with CF type I, as a low profile connector for a compact memory card can be provided.

Additionally, the structure of second supports can be downsized and simplified as mechanisms to detect any compact memory card compliant with the second specification staying in the adapter can be eliminated. This can provide a cheaper second supports. At the same time, parts consisting of the signal processing circuit can be arranged easily for the card adapter, CF type I compliant shape, having the signal processing circuit to convert signals between the first specification and second specifications.

Additionally, the thickness limit of circuit board of the card adapter, CF type I compliant shaped, having the signal processing circuit is widened, as an area of upper board of circuit boards that is folded corresponding to the compact card holder is removed. This makes it unnecessary to use a thin circuit board.

Additionally, the distance between the main board and sub board of the circuit board folded to opposite faces and inserted into a card case is kept by circuit board supports. This can prevent parts facing each other from being damaged by collision and can make it unnecessary to dispose other materials for electrical insulation.

Additionally, resin sheets applied with rubber adhesives such as polybuden or the like to keep the distance between the main and sub boards of the circuit board folded can prevent parts facing each other from being damaged by collision. This makes it unnecessary to dispose insulation sheets for the electrical insulation.

Additionally, the present invention can provide the card adapter with CF type I compliant thickness for a type of card adapter that performs pin arrangements between the first specification and second specifications.

## Claims

1. A card adapter used to couple a compact memory card compliant with a second specification to a CF card slot compliant with a CompactFlash Association Standard or a first specification, the card adapter comprising a circuit board and a card case,
the circuit board including:
a first connector compliant with the first specification;
a second connector compliant with the second specification; and
a signal processing circuit connected to the first connector and the second connector to convert signals between the first specification and the second specification; and
the card case accommodating the circuit board and including:
an inlet for the compact memory card at right angle to an insertion direction of the card slot compliant with the first specification,
wherein a holder for the compact memory card is formed of a housing of the second connector and the card case, and the card case is used as a top portion of the holder.

2. The card adapter of claim 1,
wherein the circuit board mounts the first connector, the second connector and the signal processing circuit in a same surface, and has a foldable structure.

3. The card adapter of claim 1,
wherein the circuit board comprises a main board, a sub-board and a flexible bend to connect the main board and the sub-board, and is folded at the flexible bend to insert into the card holder, and
the main board and the sub-board faces each other in the card case.

4. The card adapter of claim 3,
wherein the sub-board mounts the first connector and the second connector in a same surface,
the main board mounts the signal processing circuit in the same surface, and
the first connector and the second connector are connected via the signal processing circuit.

5. The card adapter of claim 3,
wherein at least one of the main board and the sub-board in a folded structure has an opening equal to or wider than the holder in a portion corresponding to the holder.

6. The card adapter of claim 3,
wherein the main board is L-shaped and is positioned on the second connector housing when the main board is folded.

7. The card adapter of claim 3,
wherein the holder is formed between one surface of the card case and the sub-board.

8. The card adapter of claim 3,
wherein the holder is formed by one surface of the card case, the sub-board and the housing of the second connector.

9. The card adapter of claim 3,
wherein housing of the second connector holds a distance between the main board and the sub-board facing each other.

10. the card adapter of claim 1,
wherein the circuit board connects the first connector and the second connector electrically, and mounts a circuit to convert a pin arrangement.

11. A card adapter used to couple a compact memory card compliant with a second specification to a CF card slot compliant with a CompactFlash Association Standard or a first specification comprising a circuit board and a card case,
the circuit board including:
a first connector compliant with the first specification;
a second connector compliant with the second specification; and
a signal processing circuit connected to the first connector and the second connector to convert between signals compliant with the first specification and signals compliant with the second specification; and
the card case accommodating the circuit board and including:
an inlet for the compact memory card at right angle to an insertion direction of the card slot compliant with the first specification; and
a holder for the compact memory card inserted from the inlet,
wherein the circuit board mounts the signal processing circuit, the first connector and the second connector on one surface, and has a structure enable to fold until both of the circuit boards face each other,
and wherein the surface mounted with the signal processing circuit is appressed to a circuit board support provided on a housing of the second connector to keep a distance between both of the folded circuit boards in a prescribed dimension.

12. The card adapter of claim 11,
wherein the circuit board connects the first connector and the second connector electrically, and mounts a circuit to convert a pin arrangement.

13. A card adapter used to couple a compact memory card compliant with a second specification to a CF card slot compliant with a CompactFlash Association Standard or a first specification comprising a circuit board and a card case,
the circuit board comprising:
a first connector compliant with the first specification;
a second connector compliant with the second specification; and
a signal processing circuit connected to the first connector and the second connector to convert between signals compliant with the first specification and signals compliant with the second specification;
and
the card case accommodating and including the circuit board comprising:
an inlet for the compact memory card at right angle to an insertion direction of the card slot compliant with the first specification; and
a holder for the compact memory card inserted from the inlet;
wherein the circuit board mounts the signal processing circuit, the first connector and the second connector on one surface, and has a structure enable to fold until both of the circuit boards face each other,
and wherein the circuit board in a folded structure where the both circuit boards face each other is bonded to the card case using an insulating adhesives to keep a distance between both of the folded circuit boards in a prescribed dimension.

14. The card adapter of claim 13,
wherein the card case has a top surface and a bottom surface, and the main board is bonded inside of the top surface via an insulating adhesive layer and the sub-board is bonded inside of the bottom surface via the adhesive layer.

15. The card adapter of claim 13,
wherein the circuit board connects the first connector and the second connector electrically, and mounts a circuit to convert a pin arrangement.
